# FASCICULE DE BREVET EUROPEEN

(11) **EP 3 921 871 B1**
(45) Date de publication et mention de la délivrance du brevet: **06.09.2023**
(21) Numéro de dépôt: 20715115.0
(22) Date de dépôt: 05.02.2020
(51) Int. Cl.: H10K 50/19, H10K 50/852, H10K 59/32, H10K 59/12, H10K 102/00

(54) **DISPOSITIF D'AFFICHAGE ELECTROLUMINESCENT**
ELEKTROLUMINESZENTE ANZEIGEVORRICHTUNG
ELECTROLUMINESCENT DISPLAY DEVICE

(30) Priorité: 06.02.2019 FR 1901164
(43) Date de publication de la demande: 15.12.2021
(73) Titulaire: Microoled, 38000 Grenoble Cedex 9 (FR)
(72) Inventeur: HAAS, Gunther, 38120 ST Egreve (FR); DUGRENIL, Benoit, 38000 Grenoble (FR); THOMSCHKE, Michael, 38120 ST Egreve (FR)
(74) Mandataire: Schmidt, Martin Peter
(86) Numéro de dépôt international: PCT/FR2020/000023
(87) Numéro de publication internationale: WO 2020/161400

(56) Documents cités:
- WO-A1-2017/179514
- US-A1- 2013 082 246
- US-A1- 2016 043 146
- US-A1- 2016 126 500
- US-A1- 2018 090 719

## Description

### Domaine technique de l'invention

L'invention se rattache au domaine des dispositifs et composants optoélectroniques, et plus précisément aux dispositifs électroluminescents de type OLED (Organic Light Emitting Device). Elle concerne plus particulièrement l'amélioration de la fiabilité de la gamme de couleur d'affichage des dispositifs OLED de type tandem.

### Etat de la technique

Les dispositifs électroluminescents organiques (OLED, « Organic ElectroLuminescent Device ») suscitent un intérêt considérable pour les systèmes d'éclairage à écran plat et les écrans minces. On connaît en particulier les dispositifs OLED de type « émission par le haut », désignés parfois par le signe TOLED (« Top Emission OLED »), qui sont réalisées sous la forme d'un empilement comprenant une électrode de commande (pixelisée dans le cas de dispositifs d'affichage), au moins une couche OLED émettrice, et une électrode (semi-)transparente.

L'optimisation de ces dispositifs doit prendre en compte de nombreux aspects électroniques et optiques. Sur le plan optique, ces dispositifs forment une cavité délimitée par la surface réfléchissante de l'électrode de commande et la surface externe de l'électrode semi-transparente, comme cela est décrit dans de nombreuses publications, par exemple « RGB tricolor produced by white-based top-emitting organic light-emitting diodes with microcavity structure » par J. Cao et al., paru en 2007 dans la revue Current Applied Physics 7, p. 300-304, et « Top-emitting organic light-emitting diodes : influence of cavity design » par S. Hofmann et al., parue en 2010 dans la revue Applied Physics Letters 97, p. 253308-1 à 253308-3. Cet effet de microcavité complique considérablement la conception de ces dispositifs. La publication « Combined effects of microcavity and dielectric capping layer on bidirectional organic light-emitting diodes » par J. Lee et al., parue en 2012 dans la revue Optics Letters 37(11), p. 2007-2009, analyse cette problématique pour un dispositif OLED émettant à la fois par le haut et par le bas.

La durée de vie opérationnelle des dispositifs OLED diminue avec l'augmentation de la densité de courant ou de la luminance car le grand nombre de porteurs de charge (trous et d'électrons) traversant la couche organique électroluminescente provoque des réactions secondaires électrochimiques des composés organiques. Or, on recherche des dispositifs OLED à haute luminance, et leur durée de vie opérationnelle constitue un enjeu significatif. Une approche particulière pour résoudre ce problème est l'utilisation de deux ou plusieurs diodes OLED superposées (dispositifs dits en « tandem »), qui vise à atteindre une durée de fonctionnement plus longue sous haute luminance. On connaît notamment des dispositifs OLED tandem, dans lesquels les au moins deux couches OLED émettrices émettent chacune une lumière de couleur différente, de manière à obtenir à la sortie de l'électrode transparente une lumière blanche, qui peut ensuite traverser des filtres optiques posés sur la surface frontale du dispositif pour former des sous-pixels de couleur permettant un affichage couleur.

Plus précisément, dans une structure OLED en tandem, plusieurs (typiquement deux) unités électroluminescentes sont empilées en série, reliées par des couches d'interconnexion telles qu'une couche conductrice transparente (TCL, « Transparent Conductive Layer ») ou une couche de génération de charge (CGL, « Charge Génération Layer »). De plus, les couches d'injection d'électrons (EIL, « Electron Injection Layer ») jouent également un rôle important pour réduire la barrière d'injection d'électrons du TCL ou du CGL dans la première unité électroluminescente. Avec une densité de courant identique, comparée à un seul dispositif électroluminescent, les dispositifs OLED en tandem avec deux unités électroluminescentes superposées peuvent présenter une luminance double. Cela répond à l'objectif de fournir des écrans d'affichage à haute luminance (typiquement supérieur à 1000 cd/m² pour un écran couleur). Par conséquent, l'efficacité et la durée de vie opérationnelle des dispositifs OLED en tandem peuvent être meilleures par rapport à celles des dispositifs OLED conventionnels à une seule unité.

La géométrie tandem ne résout cependant pas tous les problèmes, puisqu'elle représente la connexion en série de deux systèmes OLED, les tensions de commande individuelles s'additionnent. Cela augmente les interactions indésirables entre pixels ou sous-pixels voisins, comme cela sera expliqué dans ce qui suit.

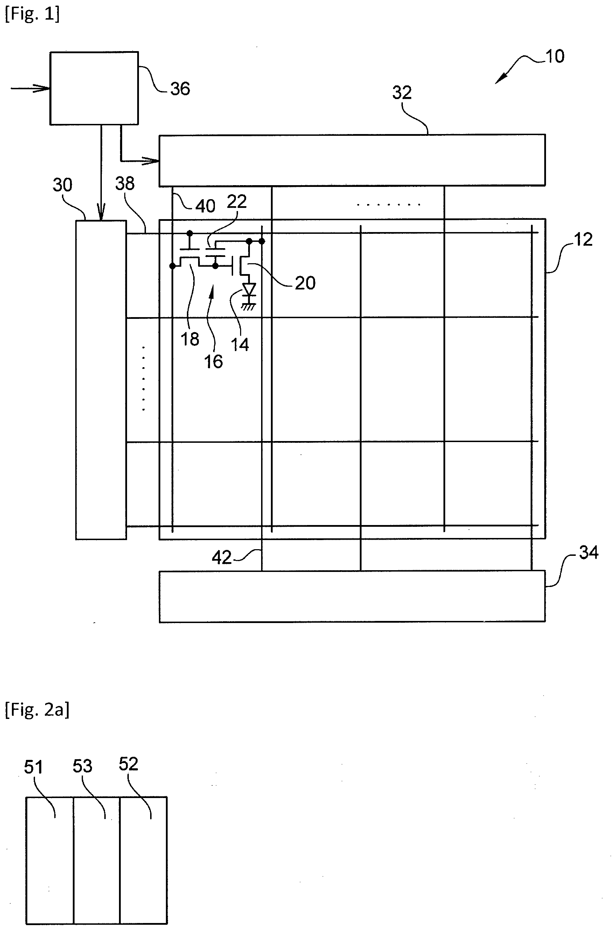

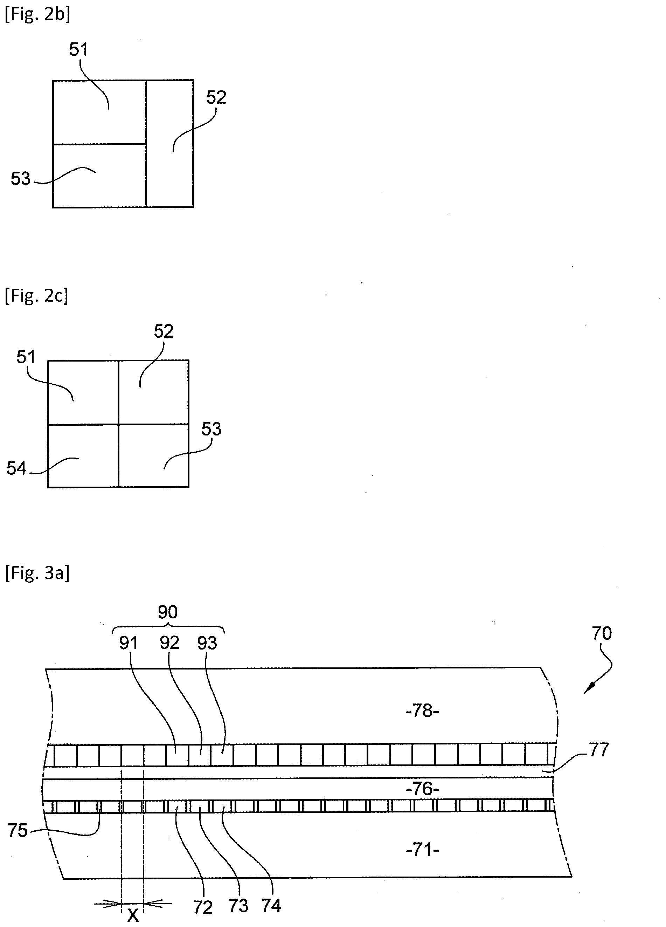

Les écrans d'affichage OLED comprennent en général une structure matricielle de pixels individuels, qui est contrôlée par une grille de pistes conductrices verticales et horizontales ; cette structure peut permettre un adressage individuel des pixels. Cela est illustré de manière schématique sur la figure 1 qui sera expliquée ci-dessous. Dans les écrans couleur chaque pixel est subdivisé en sous-pixels de différentes couleurs (typiquement trois ou quatre, dont le rouge, le vert et le bleu) qui coopèrent pour émettre un point lumineux (pixel) de couleur voulue. La figure 3(a) montre une section d'un tel écran. Au-dessus des électrodes des sous-pixels est déposé un empilement OLED qui couvre toute la surface de la matrice et qui (dans cet exemple) émet de la lumière blanche. Les couleurs primaires RGB (Red-Green-Blue, en français rouge-vert-bleu) ou RGBW (Red-Green-Blue-White, en français rouge-vert-bleu-blanc) des sous pixels sont dans ce cas générées par des filtres colorés situés au-dessus de l'empilement OLED. Une autre façon de façon de réaliser les couleurs primaires est de structurer les couches OLED en sous-pixel avec des couleurs d'émission différentes. Comme le procédé de structuration des couches OLED est assez complexe et la résolution atteignable assez limitée, on préfère même dans ce cas garder un maximum de couches communes (i.e. des couches couvrant toute la surface de la matrice), en général les couches de transport des porteurs de charges, et de ne structurer que les couches émettrices. Cependant, dans les deux cas précédents, on observe que les pixels ou sous-pixels voisins peuvent interagir, par couplage capacitif ou par des courants parasites passant notamment à travers des couches conductrices communes de l'empilement OLED.

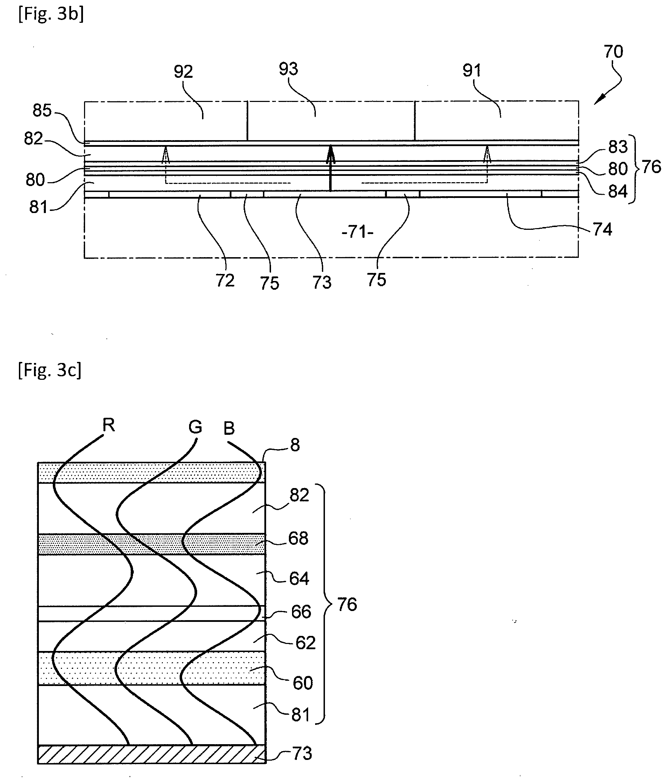

Un exemple pour ce courant parasite est illustré sur la figure 3(b) qui sera expliquée ci-dessous. Cette interaction indésirable entre des pixels ou sous-pixels voisins est connue de l'homme du métier sous le nom « crosstalk » (diaphonie) ; elle conduit surtout à la modification indésirable des couleurs dans le cas des écrans couleur. Les aspects théoriques du phénomène de diaphonie dans les dispositifs OLED ont été étudiés depuis longtemps (voir par exemple la publication de D. Braun « Crosstalk in passive matrix polymer LED displays » parue en 1998 dans la revue Synthetic Metals 92, p. 107-113). Bien connu dans le cas de dispositifs OLED à diodes simples, le phénomène de diaphonie est exacerbé dans les dispositifs OLED à diodes tandem. Les couches d'interconnexion des structures superposées en tandem présentent une conductivité électrique assez élevée, et on observe des courants parasites dans le plan des couches. Comme expliqué ci-dessus, la tension de commande d'un dispositif OLED de type tandem est plus élevée que pour un dispositif OLED simple, ce qui augmente les courants parasites. Ce problème de diaphonie devient encore plus perceptible lorsque la taille du sous-pixel diminue. Hormis la correction numérique des conséquences de la diaphonie (qui revient à accepter le phénomène de diaphonie et de diminuer son impact sur l'image), on connaît différentes approches pour lutter contre la diaphonie à la source, c'est-à-dire pour diminuer le phénomène physique au niveau du pixel ou sous-pixel.

Pour un dispositif OLED simple, il est connu de séparer chaque pixel pour les isoler les uns des autres, dans le but d'éviter les problèmes de court-circuit liés à l'humidité dans les couches d'encapsulation. Le document EP 2 927 985 A2 décrit une structure dans laquelle chaque pixel est hermétiquement scellé et isolé de ses pixels voisins. La fabrication d'une telle structure nécessite des étapes de procédé nombreuses et complexes. Il est également connu de délimiter les zones de pixel par des éléments séparateurs supplémentaires, tels que des murs, comme décrit dans le document US 9 419 245 B2. Ces procédés sont complexes et engendrent un surcoût significatif.

Les documents US 2016/126500 A1, US 2018/090719 A1, WO 2017/179514 A1, US 2013/082246 A1, US 2016/043146 A1, décrivent des dispositifs OLEDs de type Tandem comprenant plusieurs ensembles émetteurs de lumière empilés.

Compte tenu de ce qui précède, un objectif de la présente invention est de remédier, au moins partiellement, aux inconvénients de l'art antérieur évoqués ci-dessus, et de proposer une architecture pour dispositif d'affichage OLED qui permet de réduire de manière significative les courants parasites latéraux, même pour des pixels de très petite taille (typiquement inférieure à 5 µm), pour des structure à espace inter-pixel très faible, ou pour des afficheurs OLED de type tandem.

Un autre objectif de l'invention est de proposer un procédé qui permet de limiter les courants parasites entre les pixels pour un dispositif électroluminescent miniature.

### Objets de l'invention

Selon l'invention le problème est résolu par un dispositif d'affichage matriciel à couches électroluminescentes organiques de structure tandem dans lequel on contrôle l'épaisseur de la cavité optique de manière à extraire de manière préférée les ondes du 1^{er} ordre pour une longueur d'onde comprise entre 400 nm et 700 nm, et de préférence entre 420 nm et 620 nm. Ce dispositif est de type « émission par le haut »

Ce dispositif comprend successivement : un substrat, une première électrode de commande qui est structurée pour former une matrice d'affichage, un premier ensemble émetteur de lumière comprenant au moins une première couche électroluminescente organique, un deuxième ensemble émetteur de lumière comprenant au moins une deuxième couche électroluminescente organique, une deuxième électrode, de polarité opposée à ladite première électrode, et au moins partiellement transparente à la lumière émise par lesdites couches électroluminescentes, ledit dispositif dans lequel le produit entre, d'une part, la distance entre la surface opposée au substrat de ladite électrode de commande et la surface côté substrat de ladite deuxième électrode, d_{Cavité}, et, d'autre part, l'indice optique moyen des couches organiques se trouvant entre ces deux surfaces, n, est compris entre n*d_{Cavité} = 125 nm et 205 nm, de préférence entre 145 nm et 195 nm, et encore plus préférentiellement entre 155 nm et 180 nm. Le dispositif de la présente invention est décrit dans la revendication 1. Les détails additionnels sont décrits dans les revendications dépendantes 2-9.

### Description des figures

Les figures 1 à 3 illustrent des aspects généraux, connus, des dispositifs et afficheurs OLED. Les figures 4 et 5 illustrent certains aspects et modes de réalisation de l'invention ; elles n'ont pas pour vocation de limiter la portée de l'invention.
[Fig. 1] montre le schéma électrique d'un écran matriciel de type OLED de type connu.
La figure 2 montre trois exemples connus de disposition de sous-pixels de couleurs différentes pour former un pixel capable d'afficher la couleur voulue.
[Fig. 2a] montre un exemple connu de disposition de sous-pixels de couleurs différentes pour former un pixel capable d'afficher la couleur voulue.
[Fig. 2b] montre un autre exemple connu de disposition de sous-pixels de couleurs différentes pour former un pixel capable d'afficher la couleur voulue.
[Fig. 2c] montre encore un autre exemple connu de disposition de sous-pixels de couleurs différentes pour former un pixel capable d'afficher la couleur voulue.
La figure 3 montre de manière schématique une coupe transversale perpendiculaire d'un pixel dans un afficheur OLED de type « émission par le haut » selon l'état de la technique, avec un OLED à émission blanche et des filtres de couleur.
[Fig. 3a] montre plusieurs pixels d'un tel dispositif.
[Fig. 3b] montre un seul pixel de ce dispositif, avec trois sous-pixels.
[Fig. 3c] montre de manière schématique la conception optique d'un sous-pixel d'une configuration tandem selon un autre mode de réalisation connu.
[Fig. 4] est une vue en coupe transversale perpendiculaire illustrant un dispositif suivant l'un des modes de réalisation de l'invention.
La figure 5 illustre, sous la forme d'une vue en coupe transversale perpendiculaire, un mode de réalisation d'une couche de génération de charges utilisable dans un dispositif selon l'invention.
[Fig. 5a] montre une vue en coupe transversale perpendiculaire d'un mode de réalisation selon l'invention.
[Fig. 5b] montre une vue en coupe transversale perpendiculaire d'une variante de ce mode de réalisation.

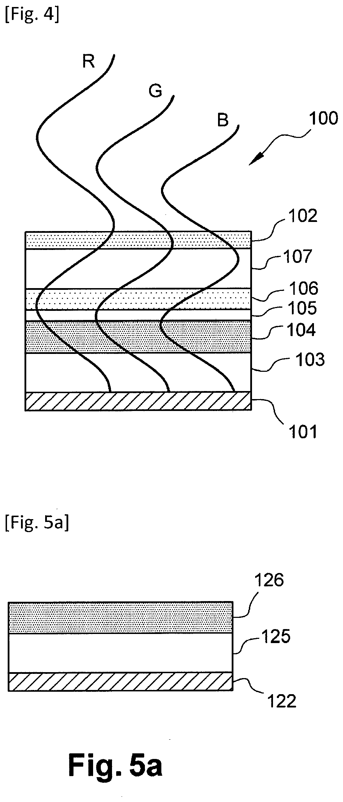

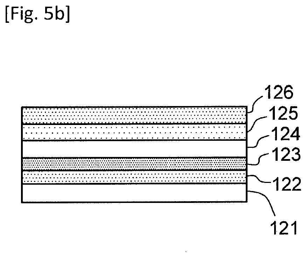

Dans ces figures 4 et 5, la couleur des différentes couches n'a pas de signification et sert uniquement à distinguer deux couches voisines.

Les références numériques suivantes sont utilisées dans la présente description.

**[Table 1]**

| Réf. | Descriptif | Réf. | Descriptif |
|---|---|---|---|
| 10 | Afficheur OLED (de type connu) | 12 | Matrice de pixels |
| 14 | Diode OLED | 16 | Circuit de commande de 12 |
| 18 | Transistor à effet de champ | 20 | Transistor à effet de champ |
| 22 | Condensateur | 30 | Circuit de commande pour lignes |
| 32 | Circuit d'adressage vidéo | 34 | Circuit d'alimentation électrique pour colonnes |
| 36 | Unité de commande | 38 | Piste conductrice pour lignes |
| 40 | Piste conductrice (signal vidéo) | 42 | Piste conductrice d'alimentation pour colonnes |
| 50 | Pixel | 51 | Sous-pixel rouge |
| 52 | Sous-pixel bleu | 53 | Sous-pixel vert |
| 54 | Sous-pixel blanc | 60 | 1^{ère} couche électroluminescente |
| 62,6 4 | Couche fonctionnelle organique | 66 | Couche de génération de charge |
| 68 | 2^{ème} couche électroluminescente | 70 | Afficheur OLED (de type connu) |
| 71 | Substrat | 72,73, 74 | Electrode de commande de sous-pixel |
| 75 | Elément de remplissage (gap-fill) | 76 | Empilement OLED |
| 77 | Couche d'encapsulation | 78 | Tranche de verre |
| 80 | Couche électroluminescente de 76 | 81,82 | Couche d'injection et de transport de charges |
| 83 | Couche de blocage de charges | 84 | Couche de blocage de charges |
| 85 | Electrode | 90 | Ensemble de filtres colorés pour un pixel |
| 91 | Filtre bleu pour sous-pixel | 92 | Filtre rouge pour sous-pixel |
| 93 | Filtre vert pour sous-pixel | | |
| 100 | Système OLED selon l'invention | 101 | Electrode de commande (anode) |
| 102 | Electrode commune (cathode) | 103 | 1^{ère} couche organique fonctionnelle |
| 104 | 1^{ère} couche électroluminescente (émettrice) | 105 | Couche de génération de charges |
| 106 | 2^{ème} couche électroluminescente (émettrice) | 107 | 2^{ème} couche organique fonctionnelle |
| 121 | Couche de blocage des trous | 122 | Couche de transport d'électrons |
| 123 | Couche d'injection d'électrons | 124 | Couche d'injection de trous |
| 125 | Couche de transport de trous | 126 | Couche de blocage des électrons |

### Description détaillée

Sauf mention contraire, le concept de « conductivité » utilisé dans cette description se rapporte à la conductivité électrique.

La figure 1 montre de manière schématique le circuit d'un afficheur OLED **10** de type connu qui comprend une unité de matrice de pixels **12** capable de produire une image, et une unité de commande **36.** Les diodes OLED **14** et leurs circuits de commande **16** sont disposés de manière à former des pixels dans l'unité de matrice de pixels **12,** ladite matrice de pixels comportant des lignes (horizontales) et des colonnes (verticales). Chaque circuit de commande **16** d'un pixel **12** comprend une pluralité de transistors en couche mince **18,20** (typiquement en technologie CMOS (Complementary Metal Oxyde Semiconductor) ou TFT (« Thin Film Transistor »)) et un condensateur **22.** L'unité de commande **36** commande un circuit de commande pour les lignes **30** et un circuit d'adressage vidéo **32,** ainsi qu'un circuit d'alimentation électrique **34** pour l'adressage des colonnes de pixel ; elle assure l'adressage des circuits de pixel et contrôle l'émission lumineuse des diodes OLED **14.**

Le circuit de commande des lignes **30** est relié aux pistes conductrices **38** adressant les lignes de balayage de la matrice de pixel. Il sélectionne les lignes de balayage **38** selon un signal en provenance de l'unité de commande **36,** et applique une tension pour allumer les transistors à effet de champ TFT **18** se trouvant sur la ligne de balayage **38** sélectionnée. Le circuit d'adressage vidéo **32** est relié à des pistes conductrices **40** adressant les colonnes du signal vidéo. Le circuit d'adressage vidéo **32** reçoit un signal vidéo de l'unité de commande **36** et envoie une tension sur les pistes conducteurs vidéo **40** des colonnes selon les pistes conductrices des lignes sélectionnées par le du circuit de commande **30** correspondant. Ce signal de tension est inscrit dans le condensateur **32** à travers le transistor à effet de champ TFT **18** de la diode OLED **14** de la ligne de pixel sélectionnée. Le transistor à effet de champ TFT **20** de commande envoie un courant correspondant à la tension enregistrée à la diode OLED **14,** et de ce fait la diode OLED **14** de la ligne sélectionnée **38** émet de la lumière.

Le circuit d'alimentation électrique **34** est relié aux pistes conductrices d'alimentation **42** des colonnes de pixel ; il alimente les diodes OLED **14** par l'intermédiaire des pistes conductrices **32** et des transistors à effet de champ TFT **20** de la ligne de pixels sélectionnée.

Ce principe d'adressage d'une diode OLED formant un pixel dans une matrice de pixels, connu en tant que tel, peut être appliqué, de manière également connue en tant que telle, à l'adressage d'une diode OLED formant un sous-pixel dans une matrice de pixels d'un dispositif d'affichage à couleurs, dans lequel chaque pixel comprend une pluralité de sous-pixels (le plus souvent trois ou quatre) de couleurs différentes ; cela sera expliqué ici en relation avec la figure 2. Les figures 2(a), (b) et (c) montrent trois exemples pour la disposition géométrique de ces sous-pixels **51, 52, 53, 54** pour former un pixel **50** capable d'afficher la couleur voulue. Sur ces figures les sous-pixels sont de couleurs rouges **51,** bleue **52** et verte **53,** et peuvent comprendre, comme sur la figure 2(c), en plus un sous-pixel blanc **54** pour augmenter la luminosité du pixel **50.** L'arrangement de la figure 2(a) est connue sous le sigle « RGB Stripe », qui est le plus répandu. L'arrangement de la figure 2(c) est connu sous le sigle« RGBW quad ».

Le principe d'adressage qui vient d'être décrit en relation avec les figures 1 et 2 est l'un des principes d'adressage qui peuvent être mis en oeuvre en relation avec la présente invention. La couleur peut être obtenue par le contrôle de la couleur émise par les couches OLED formant les sous-pixels, ou par des filtres de couleurs qui modifient la couleur blanche de la lumière émise par les sous-pixels, comme cela sera expliqué ci-dessous en relation avec la figure 3.

La figure 3 montre de manière schématique des modes de réalisation de micro-afficheurs OLED selon l'état de la technique ; elle illustre le problème que la présente invention cherche à résoudre. Sur la figure 3(a) est montrée une vue schématique globale de la structure du dispositif **70** selon un premier mode de réalisation connu : on distingue le substrat **71** (de type CMOS ou TFT, les circuits et composants d'adressage ne sont pas montrés), les électrodes de commande **72,73,74** des sous-pixels séparés par un élément de remplissage (« gap-fill ») **75,** la couche OLED **76** apte à émettre une lumière blanche, la couche d'encapsulation **77,** les filtres colorés de couleur bleue **91,** rouge **92** et verte **93** formant un ensemble de filtres colorés pour pixel **90,** la tranche de verre **78** comme couverture protectrice. La taille des sous-pixels X est typiquement de l'ordre de 3,5 µm à 5 µm. On note que dans ce dispositif selon l'état de la technique, la couche OLED **76** s'étend sur toute la surface du dispositif. Le dispositif est de type « émission par le haut » (en anglais « top émission »), c'est-à-dire que l'émission de la lumière générée par l'OLED se fait dans la direction opposée au substrat **71,** les circuits de type MOS ou TFT étant réalisés sur une tranche de silicium.

La figure 3(b) montre une vue agrandie d'un dispositif similaire à celui représenté sur la figure 3(a) ; cette vue se limite à un ensemble de filtres colorés pour un seul pixel **90.** Les sous-pixels sont définis, d'une part, par les électrodes **72, 73, 74** qui permettent leur adressage individuel, et par les filtres colorés correspondants **91, 92, 93** qui modifient la lumière émise par la couche OLED **76** à émission blanche qui s'étend sur toute la surface du dispositif. L'espace entre deux électrodes de commande de sous-pixel voisines **72, 73** peut être rempli par un élément de remplissage **75.** Ladite couche OLED **76** est réalisé comme empilement de plusieurs couches et comprend la couche électroluminescente **80** proprement dite, qui est prise en sandwich entre deux couches de blocage de charges **83,84** et deux couches de transport de charges **81, 82.** Plus précisément, dans un dispositif typique, la couche **81** comprend une couche d'injection et de transport de trous, et la couche **82** une couche d'injection et de transport d'électrons. Mais il est aussi possible d'utiliser un empilement dit « inverse », dans ce cas la couche **82** comprend une couche d'injection et de transport de trous, et la couche **81** une couche d'injection et de transport d'électrons. Les couches **81** et **82** peuvent comprendre respectivement une seule couche qui remplit à la fois les deux fonctions l'injection et transport des charges respectives, ou plusieurs couches, par exemple une couche pour l'injection et une autre pour le transport des charges respectives. Une électrode commune **85** évacue les charges.

Ce dispositif selon l'état de la technique présente des courants parasites dans le plan des couches ; cela est illustré sur la figure 3(b). En effet, si lors de l'allumage d'un sous-pixel (par exemple **73**) le courant principal traverse (marqué par une flèche épaisse) directement l'empilement OLED **76** dans le sens le plus court (i.e. vertical par rapport au substrat **71**), une partie du courant se propage selon d'autres chemins de conduction, dans la mesure où ces chemins de conduction présentent une résistivité suffisamment faible. Ainsi on observe un courant parasite qui se propage dans la couche de transport de charges **81,** à savoir dans le plan du substrat, et qui ensuite traverse l'empilement OLED dans le sous-pixel voisin **72** ou **74.** Ce courant parasite est marqué par deux flèches latérales. L'empilement OLED **76** comprend dans sa caractéristique la plus simple une couche électroluminescente **80** comme précédemment décrit dans les figures 3(a) et 3(b).

La figure 3(c) illustre la conception optique d'un sous-pixel d'une configuration tandem selon un autre mode de réalisation connu. L'empilement OLED **76** comprend au moins deux couches émettrices, une première couche émettrice jaune **60** (qui est de préférence du type phosphorescent) et une deuxième couche émettrice bleue **68** (qui est de préférence de type fluorescent).

Plus précisément, l'empilement OLED **76** comprend une électrode de commande de sous pixel **73** qui joue le rôle de l'anode, une première couche fonctionnelle organique **81** de type transport de charge ou d'injection, une première couche émettrice jaune **60** de type phosphorescente (PH-EL), une seconde couche fonctionnelle organique **62** de type transport d'électrons, une couche de génération de charge **66** (CGL), une troisième couche fonctionnelle organique **64** de type transport des trous, une seconde couche émettrice bleu **68** de type fluorescente (FL-EL), une quatrième couche fonctionnelle organique **82** de type transport d'électrons, et l'électrode **85** de type cathode. L'ordre indiqué s'entend dans la direction de l'émission optique du dispositif (i.e. d'en bas vers le haut dans le sens de la figure 3(c)).

On constate que les couches intermédiaires de cet élément OLED, visibles sur les figures 3(a)(b)(c), accentuent les courants parasites dans le plan des couches. Cela génère une émission lumineuse parasite dans les sous-pixels voisins, qui modifie la résolution d'image de l'afficheur et diminue la fidélité de sa couleur. La présente invention cherche à fournir un moyen pour diminuer ce courant parasite.

La figure 4 illustre une vue en coupe d'un système OLED **100** de type tandem selon un mode de réalisation de l'invention. Il comprend une électrode de commande de sous-pixel **101** (qui est en règle générale l'anode), une première couche fonctionnelle organique **103** de type transport de charges ou d'injection de charges, une première couche électroluminescente **104** de lumière fluorescente bleue (FL-EL), une couche de génération de charges **105** (CGL), une seconde couche électroluminescente **106** de lumière phosphorescente jaune, ou verte et rouge (PH-EL), une seconde couche fonctionnelle organique **107** de type transport de charges ou d'injection de charges, et une électrode commune **102** de type cathode.

Pour une émission de lumière par le haut, comme sur la figure 4, l'électrode de commande de sous-pixel **101** est avantageusement réfléchissante ; une couche d'un élément métallique ou d'un alliage métallique peut convenir. En revanche, l'électrode commune **102** de type cathode est transparente ou semi-transparente.

La couche de génération de charges **105** peut être une couche unique, selon un mode de réalisation non revendiqué, ou, selon l'invention revendiquée, composée de plusieurs couches.

Les couches organiques fonctionnelles peuvent avoir différentes fonctions, simultanément ou dans des variantes différents. Il peut s'agir de couches de transport de charges, de couches de blocage de charges, de couches d'adhérence (en anglais prime layer), de couches optiques. Des exemples seront donnés ci-dessous.

Pour avoir une intensité lumineuse optimale l'épaisseur des couches doit être contrôlée avec soin. Plus précisément, il faut choisir les épaisseurs des différentes couches de façon à ce que les zones d'émission bleue et jaune (ou vert et rouge) soient dans une position favorable dans la cavité optique afin de garantir une efficacité optique maximale, et en même temps d'obtenir le point blanc (i.e. le rapport entre le composant jaune et bleu) souhaité. Selon l'invention, on utilise pour cela une émission de premier ordre pour le bleu et le jaune, comme cela est représenté schématiquement sur la figure 4 par les ondes.

On donne ici quelques explications sur la réalisation d'un tel dispositif.

Le substrat (non montré sur la figure 4, il se trouve avantageusement en-dessous de l'électrode de commande **101**) peut être un dispositif de type CMOS (typiquement réalisé sur une tranche de silicium), ou un dispositif de type TFT (typiquement réalisé avec du silicium amorphe, du silicium polycristallin, et/ou en tant que TFT de type oxyde ou autre) qui peut être déposé sur une tranche de verre ; ce substrat peut être transparent, semi-transparent ou opaque.

L'électrode de sous-pixel **101** peut être en métal (notamment en aluminium), d'une épaisseur typique comprise entre 20 nm et 1 000 nm, et de préférence entre 100 nm et 300 nm, et optionnellement couverte d'une couche mince qui la protège contre l'oxydation à l'air ; cette couche de protection peut être une couche de TiN (préféré), de MoOs, ou d'un autre matériau similaire présentant une stabilité à l'air et une conductivité suffisantes. Le pas de sous-pixel est avantageusement compris entre 1 µm et 100 µm, et de manière préférée entre 2 µm et 10 µm. La distance entre deux sous-pixels est typiquement comprise entre 0,1 µm et 10 µm, et avantageusement entre 0,2 µm et 1,0 µm. Un séparateur peut être utilisé entre deux sous-pixels ; ce séparateur peut par exemple être en matériau diélectrique organique (par exemple en résine photosensible (photorésist) ou en époxy) ou en matériau diélectrique inorganique (par exemple silice, SiN, alumine), et il peut remplir tout ou partie de l'espace entre deux sous-pixels.

Le dispositif **100** selon l'invention forme une cavité optique, les ondes de lumière générées par les couches émettrices étant envoyés dans les deux directions par rapport au plan du dispositif ; les ondes sont, par conséquent, réfléchies, partiellement, à l'interface avec l'électrode commune **102,** qui est semi-transparente, et totalement à l'interface de l'électrode de commande **101.** La longueur des ondes générées par les au moins deux couches émettrices n'étant pas la même, et cette lumière n'étant pas monochromatique, les ondes subissent des interférences différentes selon leur longueur d'onde respective. D'une manière générale, une mauvaise extraction des photons générés par l'électroluminescence diminue l'efficacité du dispositif électroluminescent. Si la cavité est mal dimensionnée et ne permet pas l'extraction efficace des photons générés, il faut, pour obtenir une luminance visée, produire plus de photons pour compenser cette perte d'efficacité optique ; pour générer davantage de photons on peut augmenter la densité de courant, mais cela diminue la durée de vie du dispositif. Les dispositifs tandem génèrent théoriquement deux fois plus de lumière, mais, selon l'état de la technique, sont plus épais que les dispositifs simples, ce qui accentue le problème de l'extraction des photons de la cavité optique.

Selon l'invention, l'épaisseur totale des couches à effet optique est optimisée pour obtenir un système favorisant la réponse de premier ordre sur au moins une partie du spectre visible, et de préférence pour la lumière bleue du spectre visible. Cela nécessite une adaptation de l'architecture du dispositif électroluminescent de type tandem.

Comme indiqué ci-dessus, la couche de génération de charges **105** peut être réalisée sous la forme d'un système de plusieurs couches fonctionnelles. Selon l'invention revendiquée, comme illustré schématiquement sur la figure 5(b), ladite couche de génération de charges **105** comprend : une couche de blocage de trous (HBL, « Hole Blocking Layer ») **121,** une couche de transport d'électrons (ETL, « Electron Transport Layer ») **122,** une couche d'injection d'électrons optionnelle (EIL, « Electron Injection Layer ») **123,** une couche d'injectior de trous (HIL, «Hole Injection Layer ») **124,** une couche de transport de trous (HTL « Hole Transport Layer ») **125** et une couche de blocage d'électrons (EBL, « Electron Blocking Layer ») **126.** L'ordre indiqué s'entend dans la direction de l'émission optique du dispositif (i.e. d'en bas vers le haut dans le sens de la figure 4). Selon un mode de réalisation non revendiqué, les couches de HBL **121,** EIL **123** et EBL **126** sont optionnelles et peuvent être absentes ; une variante, selon un mode de réalisation non revendiqué, où l'ensemble desdites couches optionnelles est absent est montrée sur la figure 5(a), d'autres où il y a seulement une ou deux desdites couches optionnelles absentes sont possible.

Dans un mode de réalisation non revendiqué, la couche de génération de charges **105** est composée successivement :
- d'une couche de transport d'électrons (ETL) **122,** ladite couche ETL comprenant une première couche ETL non dopée et une seconde couche ETL dopée N ;
- d'une couche HIL **124 ;** et
- d'une couche HTL **125,** ladite couche HTL comprenant une première couche HTL dopée P et une seconde couche HTL non dopée.

De manière préférée, chacune des couches ETL, ETL dopée N et HTL dopée P et HTL présente une épaisseur comprise entre 4 nm et 6 nm (elle peut par exemple être d'environ 5 nm), et la couche HIL **124** présente une épaisseur comprise entre 0,6 nm et 1,5 nm (elle peut par exemple être d'environ 1 nm).

Les couches fonctionnelles organiques **103,107** sont avantageusement très minces, d'épaisseur inférieure à 25 nm, ce qui contribue à réduire la diaphonie entre sous-pixels voisins. Ces couches peuvent être composées de plusieurs couches ayant des fonctions différentes.

Dans un première mode de réalisation la première couche organique fonctionnelle **103** comprend une couche de transport de trous (HTL). Selon l'invention, elle est composée (en commençant du côté de l'électrode de pixel **101**) d'une couche d'injection de trous (HIL), de ladite couche de transport de trous (HTL), et d'une couche de blocage d'électrons (EBL, Electron Blocking Layer »).

Dans un deuxième mode de réalisation, qui est combiné avec le premier qui vient d'être présenté, la deuxième couche organique fonctionnelle **107** comprend une couche de transport d'électrons (ETL). Selon l'invention, elle est composée (en commençant du côté de la couche émettrice **106**) d'une couche de blocage de trous (HBL, Hole Blocking Layer »), de ladite couche de transport d'électrons (ETL, « Electron Transport Layer »), et d'une couche de d'injection d'électrons (EIL, «Electron Injection Layer »).

La surface opposée au substrat de la première couche émettrice **104** présente une distance A par rapport à la surface opposée au substrat de l'électrode pixélisée **101** qui est entre 0.3*d_{cavité} et 0.5* d_{cavité}, et préférentiellement entre 0.35* d_{cav}ité et 0.45* d_{cavité}, d_{cavité} étant l'épaisseur de la cavité, c'est-à-dire la distance entre la surface opposée au substrat de ladite électrode de commande et la surface côté substrat de ladite deuxième électrode. Cette distance A s'entend mesurée à la surface de ladite couche qui est opposée au substrat ; elle comprend donc l'épaisseur de ladite couche. Il peut s'agir d'une couche fluorescente à émission bleue (obtenue par exemple par dopage d'une couche électroluminescente organique convenablement choisie).

La surface opposée au substrat de la deuxième couche électroluminescente **106** présente une distance B par rapport à la surface opposée au substrat de l'électrode pixélisée **101** qui est entre 0.75* d_{cavité} et 0.95* d_{cavité}, et de préférence entre 0.8* d_{cavité} et 0.9* d_{cavité}, d_{cavité} étant l'épaisseur de la cavité, c'est-à-dire la distance entre la surface opposée au substrat de ladite électrode de commande et la surface côté substrat de ladite deuxième électrode. Cette distance B s'entend mesurée à la surface de ladite couche qui est opposée au substrat ; elle comprend donc l'épaisseur de ladite couche. Il peut s'agir d'une couche phosphorescente à émission jaune ou rouge et verte (obtenue par exemple par dopage d'une couche électroluminescente organique convenablement choisie).

Ces première **104** et deuxième **106** couches électroluminescentes sont séparées par une couche de génération de charges **105,** qui est un système de plusieurs couches fonctionnelles. Avantageusement le produit de l'épaisseur totale du système de couches de génération de charge **105** (cette épaisseur étant représentée par d_{CGL}) et de l'index de réfraction moyen des couches, n*d_{CGL}, est entre 10 nm et 70 nm, et plus préférentiellement entre 30 nm et 50 nm, afin de garantir l'optimisation optique et électrique du dispositif.

Cette faible épaisseur des couches engendre les avantages suivants : le couplage optique de la structure multicouches est optimisé pour une luminance maximale sur un spectre visible large, l'intensité du champ électrique dans le sens perpendiculaire au plan des couches est maximisée (sachant que le champ électrique *E* est proportionnel à *U*/*d* où *U* est la tension de commande et *d* est la distance entre les deux électrodes **101,102),** et la conductivité dans le plan des couches, qui est susceptible d'engendrer la diaphonie, est minimisée.

L'électrode commune **102** peut être une couche mince en métal (par exemple en argent ou aluminium). Son épaisseur peut être comprise entre 10 nm et 20 nm dans le cas de dispositifs à émission par le haut (comme celui représenté sur la figure 4), Cette couche est avantageusement déposée par une technique directionnelle, par exemple par évaporation thermique.

Des filtres colorés peuvent être utilisés pour réaliser les sous-pixels d'un afficheur de couleur. Ces filtres peuvent être réalisés par exemple à partir de résine photosensible (connue en micro-électronique sous le terme « photorésist ») de couleur, ou avec des filtres interférentiels convenablement structurés.

Dans un dispositif de type émission par le haut selon l'invention, l'épaisseur totale du dispositif, mesurée entre la surface réfléchissante de l'électrode de commande et la surface inférieure de la cathode semi-transparente commune, d_{cavité}, doit être choisie de manière à permettre l'extraction des ondes lumineuse du 1^{er} ordre pour la lumière avec une longueur d'onde comprise entre 400 nm et 700 nm. Le produit entre l'index de réfraction moyen des couches organiques, n, et l'épaisseur totale du dispositif telle que définie ci-dessus, n* d_{cavité} est compris entre 125 nm et 205 nm, préférentiellement comprise entre 145 nm et 195 nm, et encore plus préférentiellement entre 155 nm et 180 nm ; cette distance correspond approximativement à la longueur (dans la direction du faisceau lumineux) de la cavité optique. Le caractère approximatif de ce concept de cavité optique tient, d'une part, au fait que la lumière émise pas les couches OLED n'est pas monochromatique mais s'étend sur une certaine plage de longueurs d'onde (typiquement de la lumière blanche), et d'autre part au caractère semi-transparent de la couche d'électrode commune, et en dernier lieu à la présence deux couches émettrices disposé à une distance différente par rapport aux extrémités de la cavité optique.

### Exemples

On a réalisé des afficheurs tandem selon l'invention avec 1280 x 1024 pixels et quatre sous-pixels par pixel en disposition RGBW (Red-Green-Blue-White), avec une taille de pixel de 9,4 µm x 9,4 µm et une taille de sous-pixel de 4,7 µm × 4,7 µm. La taille de l'écran de l'afficheur était de 12,03 mm × 9,63 mm. La nature des différentes couches ainsi que leur épaisseur sont indiquées dans le tableau 1. L'épaisseur totale de la cavité optique est de 92 nm, et l'index moyen des couches organiques de 1.8.

A titre de comparaison on a fabriqué un afficheur tandem selon l'état de a technique représenté par la figure 3, qui ne différait de celui selon l'invention que par l'épaisseur des couches.

On a trouvé avec des filtres RGBW identiques une efficience de 8 cd/A pour l'afficheur selon l'état de la technique, et de 12 cd/A pour l'afficheur selon l'invention. Le gamut de couleur était inférieur à 10 % dans l'afficheur selon l'état de la technique, et supérieur à 60 % pour l'afficheur selon l'invention.

**[Table 2]**

| Tableau 1 : Structure des dispositifs selon l'invention | | | | |
|---|---|---|---|---|
| Groupe de couche | Couche individuelle | Acronyme | Epaisseur [nm] | Dopant |
| Cathode commune | Cathode semi-transparente | Cathode | 10 - 15 | - |
| Deuxième couche organique fonctionnelle | Injection d'électrons | EIL | 2 | - |
| | Transport d'électrons | ETL | 5 | N |
| | Blocage de trous / transport d'électrons | HBL | 7 | - |
| Deuxième couche électroluminescente | Emettrice jaune (phosphorencente) | PH-EL | 20 | jaune |
| Couche génératrice de charges (CGL) | Blocage d'électrons / transport de trous | EBL | 7 | - |
| | Transport de trous | HTL | 5 | P |
| | Injection de trous | HIL | 1 | - |
| | Transport d'électrons | ETL | 5 | N |
| | Blocage de trous / transport d'électrons | HBL | 5 | - |
| Première couche électroluminescente | Emettrice bleue (fluorescente) | FL-EL | 20 | Bleue |
| Première couche organique fonctionnelle | Blocage d'électrons / Transport de trous | EBL | 7 | - |
| | Transport de trous | HTL | 7 | P |
| | Injection de trous | HIL | 1 | - |
| Electrode de commande sous-pixel | Anode (pixel) | Anode | 50-500 | |

## Revendications

1. Dispositif d'affichage matriciel (100) à couches électroluminescentes organiques, comprenant successivement :
- un substrat,
- une première électrode de commande (101),
- un premier ensemble émetteur de lumière comprenant au moins une première couche électroluminescente organique (104),
- un deuxième ensemble émetteur de lumière comprenant au moins une deuxième couche électroluminescente organique (106),
- une deuxième électrode (102), de polarité opposée à ladite première électrode, et au moins partiellement transparente à la lumière émise par lesdites couches électroluminescentes ;
ladite électrode de commande (101) étant structurée pour former une matrice d'affichage ;
ledit dispositif dans lequel
- le produit entre, d'une part, la distance entre la surface opposée au substrat de ladite électrode de commande (101) et la surface côté substrat de ladite deuxième électrode (102), d_{cavité}, et, d'autre part, l'index de réfraction moyen des couches organiques se trouvant entre ces deux surfaces, n, est compris entre 125 nm et 205 nm, préférentiellement comprise entre 145 nm et 195 nm, et encore plus préférentiellement entre 155 nm et 180 nm ;
- la distance entre la surface opposée au substrat de ladite électrode de commande (101) et la surface opposée au substrat de ladite première couche électroluminescente (104) est compris entre 0,3 fois et 0,5 fois la distance entre la surface opposée au substrat de ladite électrode de commande (101) et la surface côté au substrat de ladite deuxième électrode (102), et préférentiellement entre 0,35 fois et 0,45 fois la distance entre la surface opposée au substrat de ladite électrode de commande (101) et la surface coté substrat de ladite deuxième électrode (102) ;
- la distance entre la surface opposée au substrat de ladite électrode de commande (101) et la surface opposée au substrat de ladite deuxième couche électroluminescente (106) est comprise entre 0,75 fois et 0,95 fois la distance entre la surface opposée au substrat de ladite électrode de commande (101) et la surface côté substrat de ladite deuxième électrode (102), et préférentiellement entre 0,8 fois et 0,9 fois la distance entre la surface opposée au substrat de ladite électrode de commande (101) et la surface côté substrat de ladite deuxième électrode (102) ;
- lesdits premier et deuxième ensembles émetteur de lumière sont séparés par un empilement de couches fonctionnelles (105), chaque couche fonctionnelle assurant au moins une des fonctions suivantes : (i) le blocage des trous et transport des électrons ; (ii) le transport des électrons ; (iii) une injection des électrons ; (iv) une injection des trous ; (v) le transport des trous ; (vi) le blocage des électrons et le transport des trous; et sont de préférence séparées par un empilement de six couches fonctionnelles, chacune assurant l'une de ces six fonctions ;
- ladite première couche électroluminescente organique et ladite première électrode sont séparées par un empilement de couches fonctionnelles (103) chaque couche fonctionnelle assurant au moins une des fonctions suivantes :
(i) le blocage des électrons et le transport des trous ; (ii) l'injection de trous ;
(iii) le transport de trous ; et sont de préférence séparées par un empilement de trois couches, chacune assurant l'une de ces trois fonctions ;
ledit dispositif comprend successivement :
(1) le substrat ;
(2) la première électrode de commande, qui est une anode ;
(3) une première couche d'injection de trous, d'une épaisseur comprise entre 0,4 nm et 1,5 nm ;
(4) une première couche de transport de trous, d'une épaisseur comprise entre 4 nm et 10 nm ;
(5) une première couche de blocage d'électrons et de transport de trous, d'une épaisseur comprise entre 4 nm et 10 nm ;
(6) la première couche électroluminescente organique (104), d'une épaisseur comprise entre 10 nm et 30 nm, et de préférence entre 15 nm à 25 nm ;
(7) une première couche de blocage de trous et de transport d'électrons (121), d'une épaisseur comprise entre 3 nm et 7 nm ;
(8) une première couche de transport d'électrons (122), d'une épaisseur comprise entre 3 nm et 7 nm ;
(9) une deuxième couche d'injection de trous (124), d'une épaisseur comprise entre 0,4 nm et 1,5 nm ;
(10) une deuxième couche de transport de trous (125), d'une épaisseur comprise entre 3 nm et 7 nm ;
(11) une deuxième couche de blocage d'électrons et de transport de trous (126), d'une épaisseur comprise entre 4 nm et 10 nm ;
(12) la deuxième couche électroluminescente organique (106), d'une épaisseur comprise entre 10 nm et 30 nm, et de préférence entre 15 nm et 25 nm ;
(13) une deuxième couche de blocage de trous et de transport d'électrons, d'une épaisseur comprise entre 4 nm et 10 nm ;
(14) une deuxième couche de transport d'électrons, d'une épaisseur comprise entre 3 nm et 7 nm ;
(15) une première couche d'injection d'électrons, qui est optionnelle ;
(16) la deuxième électrode, qui est une cathode, au moins partiellement transparente à la lumière émise par lesdites couches électroluminescentes, et dont l'épaisseur est comprise entre 5 nm et 25 nm, et de préférence entre 8 nm et 20 nm.

2. Dispositif selon la revendication 1, dans lequel la première couche d'injection d'électrons présente une épaisseur comprise entre 1,2 nm et 2,5 nm.

3. Dispositif selon la revendication 1 ou 2, dans lequel lesdites couches ont l'épaisseur suivante : la première couche d'injection de trous 0,7 nm à 1,3 nm ; la première couche de transport de trous 5 nm à 9 nm ; la première couche de blocage d'électrons et de transport de trous 5 nm à 9 nm ; la première couche électroluminescente organique 15 nm à 25 nm et de préférence 17 nm à 23 nm ; la première couche de blocage de trous et de transport d'électrons 4 nm à 6 nm ; la première couche de transport d'électrons 4 nm à 6 nm ; la deuxième couche d'injection de trous 0,7 nm à 1,3 nm ; la deuxième couche de transport de trous 4 nm à 6 nm ; la deuxième couche de blocage d'életrons et de transport de trous 5 nm à 9 nm ; la deuxième couche électroluminescente organique 15 nm à 25 nm et de préférence 17 nm à 23 nm; la deuxième couche de blocage de trous et de transport d'électrons 5 nm à 9 nm ; la deuxième couche de transport d'électrons 4 nm à 6 nm ; la première couche d'injection d'électrons 1,7 nm à 2,3 nm ; la deuxième électrode 8 nm à 20 nm et de préférence 10 nm à 15 nm.

4. Dispositif selon l'une quelconque des revendications 1 à 3, lequel ne comprend pas ladite première couche d'injection d'électrons.

5. Dispositif selon l'une quelconque des revendications 1 à 4, dans lequel ladite première couche électroluminescente organique est une couche fluorescente, de préférence à émission bleue, et ladite deuxième couche électroluminescente organique est une couche phosphorescente, de préférence à émission jaune.

6. Dispositif selon l'une quelconque des revendications 1 à 4, dans lequel ladite deuxième couche électroluminescente organique est une couche fluorescente, de préférence à émission bleue, et ladite première couche électroluminescente organique est une couche phosphorescente, de préférence à émission jaune.

7. Dispositif selon l'une quelconque des revendications 1 à 4, dans lequel ladite première couche électroluminescente organique est une couche fluorescente, de préférence à émission bleue, et ladite deuxième couche électroluminescente organique est une couche phosphorescente, de préférence à émission rouge et verte.

8. Dispositif selon l'une quelconque des revendications 1 à 4, dans lequel ladite deuxième couche électroluminescente organique est une couche fluorescente, de préférence à émission bleue, et ladite première couche électroluminescente organique est une couche phosphorescente, de préférence à émission rouge et verte.

9. Dispositif selon l'une quelconque des revendications 1 à 8, dans lequel ladite deuxième électrode est une électrode commune à tous les pixels.

## Patentansprüche

1. Matrixanzeigevorrichtung (100) mit organischen Elektrolumineszenzschichten, nacheinander umfassend:
- ein Substrat,
- eine erste Steuerelektrode (101),
- eine erste lichtemittierende Baugruppe, die mindestens eine erste organische Elektrolumineszenzschicht (104) umfasst,
- eine zweite lichtemittierende Baugruppe, die mindestens eine zweite organische Elektrolumineszenzschicht (106) umfasst,
- eine zweite Elektrode (102), die eine entgegengesetzte Polarität zur ersten Elektrode aufweist und in Bezug auf das von den elektrolumineszierenden Schichten emittierte Licht zumindest teilweise transparent ist;
wobei die Steuerelektrode (101) so strukturiert ist, dass sie eine Anzeigematrix bildet;
wobei in dieser Vorrichtung
- das Produkt aus, einerseits, dem Abstand zwischen der dem Substrat gegenüberliegenden Oberfläche der Steuerelektrode (101) und der Oberfläche auf der Substratseite der zweiten Elektrode (102), d_{cavity}, und, andererseits, dem mittleren Brechungsindex der organischen Schichten zwischen diesen beiden Oberflächen, n, zwischen 125 nm und 205 nm, vorzugsweise zwischen 145 nm und 195 nm, und noch bevorzugter zwischen 155 nm und 180 nm liegt;
- der Abstand zwischen der Oberfläche gegenüber dem Substrat der Steuerelektrode (101) und der Oberfläche gegenüber dem Substrat der ersten Elektrolumineszenzschicht (104) zwischen dem 0,3-fachen und dem 0,5-fachen des Abstands zwischen der Oberfläche gegenüber dem Substrat der Steuerelektrode (101) und der Oberfläche auf der Substratseite der zweiten Elektrode (102) liegt, und vorzugsweise zwischen dem 0,35-fachen und dem 0,45-fachen des Abstands zwischen der Oberfläche gegenüber dem Substrat der Steuerelektrode (101) und der Oberfläche auf der Substratseite derselben zweite Elektrode (102);
- der Abstand zwischen der Oberfläche gegenüber dem Substrat der Steuerelektrode (101) und der Oberfläche gegenüber dem Substrat der zweiten Elektrolumineszenzschicht (106) zwischen dem 0,75-fachen und dem 0,95-fachen des Abstands zwischen der Oberfläche gegenüber dem Substrat der Steuerelektrode (101) und der Oberfläche auf der Substratseite der zweiten Elektrode (102) liegt, und vorzugsweise zwischen dem 0,8-fachen und dem 0,9-fachen des Abstands zwischen der Oberfläche gegenüber dem Substrat der Steuerelektrode (101) und der Oberfläche auf der Substratseite derselben zweite Elektrode (102);
- die ersten und zweiten lichtemittierenden Baugruppen sind durch einen Stapel von Funktionsschichten (105) getrennt, von denen jede mindestens eine der folgenden Funktionen bereitstellt: (i) Lochblockierung und Elektronentransport; (ii) Elektronentransport; (iii) Elektroneninjektion; (iv) Lochinjektion; (v) Lochtransport; (vi) Elektronenblockierung und Lochtransport; und sind vorzugsweise durch einen Stapel von sechs Funktionsschichten getrennt, von denen jede eine dieser sechs Funktionen bereitstellt;
- die erste organische elektrolumineszierende Schicht und die erste Elektrode sind durch einen Stapel von Funktionsschichten getrennt, von denen jede mindestens eine der folgenden Funktionen bereitstellt: (i) Lochblockierung und Elektronentransport; (ii) Lochinjektion; (iii) Lochtransport;
und sind vorzugsweise durch einen Stapel aus drei Schichten getrennt, von denen jede eine dieser drei Funktionen erfüllt;
und diese Vorrichtung umfasst nacheinander:
(1) ein Substrat;
(2) eine erste Elektrodenschicht, die eine Anode ist;
(3) eine erste Lochinjektionsschicht mit einer Dicke zwischen 0,4 nm und 1,5 nm;
(4) eine erste Lochtransportschicht mit einer Dicke zwischen 4 nm und 10 nm;
(5) eine erste Elektronenblockierungs- und Lochtransportschicht mit einer Dicke zwischen 4 nm und 10 nm;
(6) eine erste organische Elektrolumineszenzschicht (104) mit einer Dicke zwischen 10 nm und 30 nm und vorzugsweise zwischen 15 nm und 25 nm;
(7) eine erste Lochblockierungs- und Elektronentransportschicht (121) mit einer Dicke zwischen 3 nm und 7 nm;
(8) eine erste Elektronentransportschicht (122) mit einer Dicke zwischen 3 nm und 7 nm;
(9) eine zweite Lochinjektionsschicht (124) mit einer Dicke zwischen 0,4 nm und 1,5 nm;
(10) eine zweite Lochtransportschicht (125) mit einer Dicke zwischen 3 nm und 7 nm;
(11) eine zweite Elektronenblockierungs- und Lochtransportschicht (126) mit einer Dicke zwischen 4 nm und 10 nm;
(12) eine zweite organische Elektrolumineszenzschicht (106) mit einer Dicke zwischen 10 nm und 30 nm und vorzugsweise zwischen 15 nm und 25 nm;
(13) eine zweite Lochblockierungs- und Elektronentransportschicht mit einer Dicke zwischen 4 nm und 10 nm;
(14) eine zweite Elektronentransportschicht mit einer Dicke zwischen 3 nm und 7 nm;
(15) eine erste Elektroneninjektionsschicht, die optional ist;
(16) eine zweite Elektrodenschicht, bei der es sich um eine Kathode handelt, die gegenüber dem von den elektrolumineszierenden Schichten emittierten Licht zumindest teilweise transparent ist und deren Dicke zwischen 5 nm und 25 nm und vorzugsweise zwischen 8 nm und 20 nm liegt .

2. Vorrichtung nach Anspruch 1, wobei die erste Elektroneninjektionsschicht eine Dicke zwischen 1,2 nm und 2,5 nm aufweist.

3. Vorrichtung nach Anspruch 1 oder 2, wobei die Schichten die folgende Dicke aufweisen: die erste Lochinjektionsschicht 0,7 nm bis 1,3 nm; die erste Lochtransportschicht 5 nm bis 9 nm; die erste Elektronenblockierungs- und Lochtransportschicht 5 nm bis 9 nm; die erste organische Elektrolumineszenzschicht 15 nm bis 25 nm und vorzugsweise 17 nm bis 23 nm; die erste Lochblockierungs- und Elektronentransportschicht 4 nm bis 6 nm; die erste Elektronentransportschicht 4 nm bis 6 nm; die zweite Lochinjektionsschicht 0,7 nm bis 1,3 nm; die zweite Lochtransportschicht 4 nm bis 6 nm; die zweite Elektronenblockierungs- und Lochtransportschicht 5 nm bis 9 nm; die zweite organische Elektrolumineszenzschicht 15 nm bis 25 nm und vorzugsweise 17 nm bis 23 nm; die zweite Lochblockierungs- und Elektronentransportschicht 5 nm bis 9 nm; die zweite Elektronentransportschicht 4 nm bis 6 nm; die erste Elektronentransportschicht 1,7 nm bis 2,3 nm; die zweite Elektrode 8 nm bis 20 nm und vorzugsweise 10 nm bis 15 nm.

4. Vorrichtung nach einem der Ansprüche 1 bis 3, **dadurch gekennzeichnet, dass** sie nicht die erste Elektroneninjektionsschicht umfasst.

5. Vorrichtung nach einem der Ansprüche 1 bis 4, wobei die erste organische elektrolumineszierende Schicht eine fluoreszierende Schicht ist, vorzugsweise mit blauer Emission, und dass die zweite organische elektrolumineszierende Schicht eine phosphoreszierende Schicht ist, vorzugsweise mit gelber Emission.

6. Vorrichtung nach einem der Ansprüche 1 bis 4, wobei die zweite organische elektrolumineszierende Schicht eine fluoreszierende Schicht ist, vorzugsweise mit blauer Emission, und dass die erste organische elektrolumineszierende Schicht eine phosphoreszierende Schicht ist, vorzugsweise mit gelber Emission.

7. Vorrichtung nach einem der Ansprüche 1 bis 4, wobei die erste organische elektrolumineszierende Schicht eine fluoreszierende Schicht ist, vorzugsweise mit blauer Emission, und dass die zweite organische elektrolumineszierende Schicht eine phosphoreszierende Schicht ist, vorzugsweise mit roter und grüner Emission.

8. Vorrichtung nach einem der Ansprüche 1 bis 4, wobei die zweite organische elektrolumineszierende Schicht eine fluoreszierende Schicht ist, vorzugsweise mit blauer Emission, und dass die erste organische elektrolumineszierende Schicht eine phosphoreszierende Schicht ist, vorzugsweise mit roter und grüner Emission.

9. Vorrichtung nach einem der Ansprüche 1 bis 8, wobei die zweite Elektrode eine für alle Pixel gemeinsame Elektrode ist.

## Claims

1. Matrix display device (100) having organic electroluminescent layers, successively comprising:
- a substrate,
- a first control electrode (101),
- a first light-emitting assembly comprising at least one first organic electroluminescent layer (104),
- a second light-emitting assembly comprising at least one second organic electroluminescent layer (106),
- a second electrode (102), that has opposite polarity to said first electrode, and is at least partially transparent with respect to the light emitted by said electroluminescent layers;
said control electrode (101) being structured to form a display matrix;
said device being **characterized in that**
- the product of, on the one hand, the distance between the surface opposite the substrate of said control electrode (101) and the surface at the substrate side of said second electrode (102), d_{cavity} , and, on the other hand, the mean refraction index of the organic layers between these two surfaces, n, is comprised between 125 nm and 205 nm, preferably comprised between 145 nm and 195 nm, and more preferably between 155 nm and 180 nm;
- the distance between the surface opposite the substrate of said control electrode (101) and the surface opposite the substrate of said first electroluminescent layer (104) is comprised between 0.3 times and 0.5 times the distance between the surface opposite the substrate of said control electrode (101) and the surface at the substrate side of said second electrode (102), and preferably between 0.35 times and 0.45 times the distance between the surface opposite the substrate of said control electrode (101) and the surface at the substrate side of said second electrode (102);
- the distance between the surface opposite the substrate of said control electrode (101) and the surface opposite the substrate of said second electroluminescent layer (106) is comprised between 0.75 times and 0.95 times the distance between the surface opposite the substrate of said control electrode (101) and the surface at the substrate side of said second electrode (102), and preferably between 0.8 times and 0.9 times the distance between the surface opposite the substrate of said control electrode (101) and the surface at the substrate side of said second electrode (102);
- said first and second light-emitting assemblies are separated by a stack of functional layers (105), each of which providing at least one of the following functions: (i) hole blocking and electron transport; (ii) electron transport; (iii) electron injection; (iv) hole injection; (v) hole transport; (vi) electron blocking and hole transport; and are preferably separated by a stack of six functional layers, each one providing one of these six functions;
- said first organic electroluminescent layer and said first electrode are separated by a stack of functional layers, each of which providing at least one of the following functions: (i) hole blocking and electron transport; (ii) hole injection; (iii) hole transport; and are preferably separated by a stack of three layers, each one providing one of these three functions;
said device successively comprises:
(1) a substrate;
(2) a first electrode layer, which is an anode;
(3) a first hole injection layer, of a thickness comprised between 0.4 nm and 1.5 nm;
(4) a first hole transport layer, of a thickness comprised between 4 nm and 10 nm;
(5) a first electron-blocking and hole transport layer, of a thickness comprised between 4 nm and 10 nm;
(6) a first organic electroluminescent layer (104), of a thickness comprised between 10 nm and 30 nm, and preferably between 15 nm to 25 nm;
(7) a first hole-blocking and electron transport layer (121), of a thickness comprised between 3 nm and 7 nm;
(8) a first electron transport layer (122), of a thickness comprised between 3 nm and 7 nm;
(9) a second hole injection layer (124), of a thickness comprised between 0.4 nm and 1.5 nm;
(10) a second hole transport layer (125), of a thickness comprised between 3 nm and 7 nm;
(11) a second electron-blocking and hole transport layer (126), of a thickness comprised between 4 nm and 10 nm;
(12) a second organic electroluminescent layer (106), of a thickness comprised between 10 nm and 30 nm, and preferably between 15 nm and 25 nm;
(13) a second hole-blocking and electron transport layer, of a thickness comprised between 4 nm and 10 nm;
(14) a second electron transport layer, of a thickness comprised between 3 nm and 7 nm;
(15) a first electron injection layer, which is optional;
(16) a second electrode layer, which is a cathode, at least partially transparent with respect to the light emitted by said electroluminescent layers, and of which the thickness is comprised between 5 nm and 25 nm, and preferably between 8 nm and 20 nm.

2. Device according to claim 1, wherein first electron injection layer has a thickness comprised between 1.2 nm and 2.5 nm.

3. Device according to claim 1 or 2, wherein said layers have the following thickness: the first hole injection layer 0.7 nm to 1.3 nm; the first hole transport layer 5 nm to 9 nm; the first electron-blocking and hole transport layer 5 nm to 9 nm; the first organic electroluminescent layer 15 nm to 25 nm and preferably 17 nm to 23 nm; the first hole-blocking and electron transport layer 4 nm to 6 nm; the first electron transport layer 4 nm to 6 nm; the second hole injection layer 0.7 nm to 1.3 nm; the second hole transport layer 4 nm to 6 nm; the second electron-blocking and hole transport layer 5 nm to 9 nm; the second organic electroluminescent layer 15 nm to 25 nm and preferably 17 nm to 23 nm; the second hole-blocking and electron transport layer 5 nm to 9 nm; the second electron transport layer 4 nm to 6 nm; the first electron transport layer 1.7 nm to 2.3 nm; the second electrode 8 nm to 20 nm and preferably 10 nm to 15 nm.

4. Device according to any of claims 1 to 3, **characterized in that** it does not comprise said first electron injection layer.

5. Device according to any of claims 1 to 4, wherein that said first organic electroluminescent layer is a fluorescent layer, preferably with blue emission, and in that said second organic electroluminescent layer is a phosphorescent layer, preferably with yellow emission.

6. Device according to any of claims 1 to 4, wherein that said second organic electroluminescent layer is a fluorescent layer, preferably with blue emission, and in that said first organic electroluminescent layer is a phosphorescent layer, preferably with yellow emission.

7. Device according to any of claims 1 to 4, wherein said first organic electroluminescent layer is a fluorescent layer, preferably with blue emission, and in that said second organic electroluminescent layer is a phosphorescent layer, preferably with red and green emission.

8. Device according to any of claims 1 to 4, wherein said second organic electroluminescent layer is a fluorescent layer, preferably with blue emission, and in that said first organic electroluminescent layer is a phosphorescent layer, preferably with red and green emission.

9. Device according to any of claims 1 to 8, wherein said second electrode is an electrode common to all the pixels.
